# DEMANDE DE BREVET EUROPEEN

(11) **EP 4 815 698 A1**
(43) Date de publication de la demande: **30.09.2026**
(21) Numéro de dépôt: 26165284.6
(22) Date de dépôt: 17.03.2026
(51) Int. Cl.: H10N 30/04, H10N 30/072, H10N 30/073

(54) **PROCEDE DE PREPARATION D'UNE COUCHE MINCE EN MATERIAU FERROELECTRIQUE**

(30) Priorité: 27.03.2025 FR 2503169
(71) Demandeur: SOITEC, 38190 Bernin (FR)
(72) Inventeur: MONTOUSSE, Joachim, 38190 BERNIN (FR); DROUIN, Alexis, 38190 BERNIN (FR); LANDRU, Didier, 38190 BERNIN (FR)
(74) Mandataire: IP Trust

(57) **Abrégé**

L'invention concerne un procédé de préparation d'une couche mince monodomaine (3') en matériau ferroélectrique monocristallin, comprenant une implantation d'espèces dites « légères » dans une première face (4) d'un substrat donneur ferroélectrique (1), l'assemblage de la première face (4) du substrat donneur (1) à un substrat support (7), la fracture du substrat donneur (1) pour reporter une première couche (3) sur le substrat support et exposer une face libre (8) de la première couche (3). Le procédé comprend un traitement thermique de la face libre (8) de la première couche (3), suivi d'un amincissement de la première couche (3) pour fournir la couche mince monodomaine (3'). Selon l'invention, l'étape de finition de la première couche (3) comprend, avant ou pendant le traitement thermique, une étape d'introduction de lithium dans une épaisseur superficielle de la première couche (3).

## Description

### DOMAINE DE L'INVENTION

La présente invention concerne un procédé de préparation d'une couche mince en matériau ferroélectrique monocristalline. Plus particulièrement, elle concerne un procédé de préparation permettant de préserver le caractère monodomaine du matériau ferroélectrique dans la couche mince du produit final. Ce procédé peut notamment être exploité pour former une structure du type piézoélectrique sur isolant (POI), comprenant la couche mince reportée sur un support par l'intermédiaire d'une couche intercalaire. Une telle structure trouve son application dans les domaines de la microélectronique, des microsystèmes, de la photonique. Elle peut être exploitée pour former des composants radiofréquences (RF), en particulier des filtres ou des résonateurs à base de composants à ondes élastiques, par exemple à ondes élastiques de surface. Les propriétés électro-optiques du matériau ferroélectrique peuvent notamment être exploitées pour former des modulateurs optiques, des composants photoniques intégrés et/ou des composants de la technologie quantique.

### ARRIERE PLAN TECHNOLOGIQUE DE L'INVENTION

En préambule on rappelle qu'un matériau ferroélectrique est un matériau qui possède une polarisation électrique à l'état naturel, polarisation qui peut être renversée par l'application d'un champ électrique extérieur. On appelle domaine ferroélectrique, chaque région d'un seul tenant du matériau dans lequel la polarisation est uniforme (tous les moments dipolaires sont alignés parallèlement les uns aux autres suivant une direction donnée, appelée axe ferroélectrique). Un matériau ferroélectrique peut donc être qualifié de « monodomaine » dans le cas où ce matériau est constitué d'une seule région dans laquelle la polarisation est uniforme ou de « multidomaine » dans le cas où le matériau ferroélectrique comprend une pluralité de régions présentant des polarités pouvant être différentes.

Il existe un procédé de préparation d'une couche mince ferroélectrique obtenue par l'application de la technologie Smart Cut^{™} selon laquelle une couche mince est prélevée d'un substrat massif en matériau ferroélectrique monocristallin (désigné « substrat donneur » dans le domaine) par fracture au niveau d'une zone fragile (ou plan de fragilisation) formée par implantation d'espèces dites « légères », telles que de l'hélium et/ou de l'hydrogène. On pourra trouver un exemple particulier de mise en œuvre de ce procédé dans le document EP3646374B1.

Selon ce procédé, et après l'étape de prélèvement de la couche, il est souvent nécessaire de lui appliquer des traitements visant à améliorer son état de surface, sa qualité cristalline ou d'en modifier son épaisseur. La demanderesse a toutefois observé que ces étapes de préparation, lorsqu'elles étaient appliquées à une couche mince ferroélectrique reportée par l'intermédiaire de la technologie Smart Cut, pouvaient conduire à la formation d'une pluralité de domaines ferroélectriques au sein de la couche mince, lui attribuant ainsi un caractère multidomaine.

Une telle caractéristique rend la couche impropre à son utilisation, car elle affecte les performances des dispositifs qui sont appelés à être formés sur/dans la couche mince, comme par exemple des dispositifs acoustiques à ondes de surface (SAW).

On connaît du document FR2914492 un procédé de fabrication d'une couche mince de matériau ferroélectrique par la technologie Smart Cut. Ce document applique un champ électrique à la couche mince de manière à améliorer ou à restaurer ses propriétés ferroélectriques. Toutefois, pour être facilement applicable, ce procédé nécessite de disposer d'électrodes sur chacune des faces de la couche mince, ce qui n'est pas toujours le cas.

Le document WO2024022723 divulgue qu'une couche prélevée par l'intermédiaire de la technologie Smart Cut est particulièrement réactive. La présence des espèces légères, hydrogène et/ou hélium, et la température modérée à laquelle intervient l'étape de fracture semblent rendre le lithium de cette couche particulièrement mobile. Lorsqu'une face libre de cette couche prélevée est exposée à l'atmosphère, le lithium à proximité de cette face tend à migrer et réagir avec les hydrocarbures et l'oxygène présent naturellement dans l'atmosphère, pour former une épaisseur superficielle en Li2CO3 et/ou présentant des dendrites amorphes, riches en lithium, en hydrogène, et en autres espèces présentes dans l'atmosphère, tel que du chlore ou du fluor. Pour traiter ces phénomènes et prévenir la formation de défauts de type triangles ou dépression, le document préconise notamment de procéder au nettoyage de la face libre de la couche prélevée par brossage et à l'aide d'eau désionisée.

Le document WO2020200986 indique que la formation des domaines ferroélectriques dans une portion superficielle de la couche est provoquée par l'existence de gradients de concentration d'hydrogène dans la couche mince lors de l'application d'un traitement thermique. Cet hydrogène peut notamment correspondre aux espèces légères implantées dans le substrat massif afin d'y former la zone de fragilisation permettant d'y prélever la couche mince. La portion superficielle peut présenter une épaisseur de l'ordre de 150 nm à 200 nm ou plus. Pour restaurer de manière pérenne le caractère monodomaine de la couche mince, ce document recommande d'amincir la couche mince ferroélectrique après l'application d'un tel traitement thermique.

Dans le document WO2024223276, on observe qu'en gorgeant d'hydrogène une épaisseur superficielle de la couche mince prélevée avant l'application du l'étape de traitement thermique, on réduit l'épaisseur de la portion superficielle multidomaine. Ce document prévoit notamment de faire se succéder des étapes de nettoyage de la couche mince prélevée à l'aide d'une solution aqueuse pour dépléter une épaisseur superficielle de cette couche de son lithium et le remplacer par des éléments d'hydrogène. On peut ainsi réduire, selon ce document, l'épaisseur de la portion multidomaine à moins de 125 nm.

Toutefois, et quelle que soit la technique mise en œuvre pour limiter l'épaisseur de la portion superficielle multidomaine, son élimination par amincissement forme une limitation des procédés de l'état de la technique, car cette étape tend à rendre le procédé de fabrication plus long et plus complexe à mettre en œuvre. L'étape d'amincissement, lorsqu'elle vise à éliminer une épaisseur relativement importante, peut également conduire à détériorer l'uniformité de la couche mince prélevée, notamment lorsque cette étape est mise en œuvre par polissage.

Un procédé de préparation d'une couche mince monodomaine en matériau ferroélectrique de l'état de la technique présente donc des limitations qu'il serait souhaitable de repousser.

### OBJET DE L'INVENTION

Un but de l'invention est de proposer un procédé de préparation d'une couche mince de matériau ferroélectrique adressant en partie au moins les limitations précitées. Plus particulièrement, un but de l'invention est de proposer un procédé de préparation d'une couche mince de matériau ferroélectrique, notamment une couche ferroélectrique à base de lithium, plus rapide à mettre en œuvre que les procédés de l'état de la technique. Un autre but de l'invention est de proposer un procédé de préparation d'une couche mince ferroélectrique obtenue par détachement au niveau d'un plan de fragilisation d'un substrat donneur, dans lequel l'épaisseur de matériaux éliminée pour faire disparaître la portion superficielle multidomaine de la couche prélevée est plus réduite que l'épaisseur éliminée dans les procédés de l'état de la technique.

### BREVE DESCRIPTION DE L'INVENTION

En vue de la réalisation de l'un de ces buts, l'objet de l'invention propose un procédé de préparation d'une couche mince monodomaine en matériau ferroélectrique monocristallin, comprenant les étapes suivantes:
- une implantation d'espèces dites « légères » dans une première face d'un substrat donneur ferroélectrique pour former un plan de fragilisation et définir une première couche entre le plan de fragilisation et la première face du substrat donneur;
- l'assemblage de la première face du substrat donneur à un substrat support;
- la fracture du substrat donneur au niveau du plan de fragilisation pour reporter la première couche sur le substrat support et exposer une face libre de la première couche;
- la finition de la première couche, cette finition comprenant un traitement thermique de la face libre de la première couche, suivi d'un amincissement de la première couche pour fournir la couche mince monodomaine.

Selon l'invention, l'étape de finition de la première couche comprend, avant ou pendant le traitement thermique, une étape d'introduction de lithium dans une épaisseur superficielle de la première couche.

Selon d'autres caractéristiques avantageuses et non limitatives de l'invention, prises seules ou selon toute combinaison techniquement réalisable :
- l'étape d'introduction est mise en œuvre avant le traitement thermique ;
- l'étape d'introduction comprend l'immersion de la première couche dans une solution non aqueuse comprenant du lithium ;
- la solution comprend du LiCl, LiNO3 ou LiBF4 dans un solvant organique, tel que l'acétonitrile (CH3CN), le diméthylsulfoxyde (DMSO), l'éthanol, l'isopropanol ;
- solution contient du Li2CO3 ou du LiOH en suspension dans un solvant organique, tel que l'éthanol, le toluène ou l'acétonitrile.
- l'étape d'introduction comprend l'immersion de la première couche dans un sel de lithium fondu tel que LiNO3-KNO3, LiCl-KCl ;
- l'étape d'introduction est mise en œuvre pendant le traitement thermique ;
- le procédé de préparation comprend le dépôt d'une couche réservoir comprenant du lithium sur la première couche avant le traitement thermique ;
- l'étape d'introduction de lithium comprend le recuit de la première couche dans une atmosphère comprenant du lithium ;
- l'atmosphère comprenant du lithium est obtenue par sublimation à partir d'une source solide ;
- la source solide comprend de la poudre de LiTaO3, de Li2O, de Li2CO3 ou de LiCl ;
- l'atmosphère comprenant du lithium est obtenue par un flux gazeux contenant du lithium ;
- flux gazeux comprend un lithium sous forme organométallique tel que le butyllithium (BuLi)ou le phényllithium (PhLi).
- le procédé est dépourvu de tout traitement exposant la première couche à une solution aqueuse entre l'étape de fracture du substrat donneur et le traitement thermique de la première couche ;
- le traitement thermique est appliqué directement, sans autre étape de traitement intermédiaire, après l'étape de fracture ;
- le substrat support comprend une couche de piégeage de charges électriques.

### BREVE DESCRIPTION DES DESSINS

D'autres caractéristiques et avantages de l'invention ressortiront de la description détaillée de l'invention qui va suivre en référence aux figures annexées sur lesquelles :
[Fig. 1] [Fig. 2]

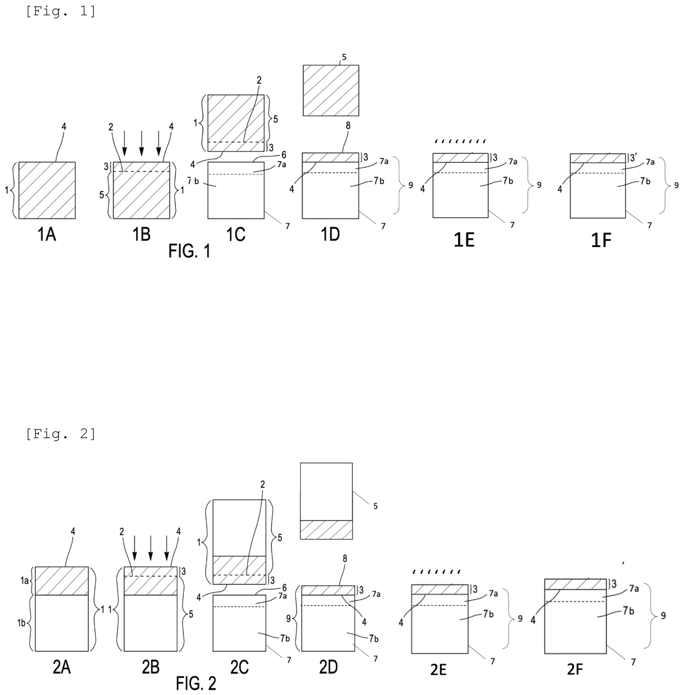

   Les figures 1 et 2 représentent deux procédés de préparation d'une couche mince monodomaine ;
[Fig. 3]

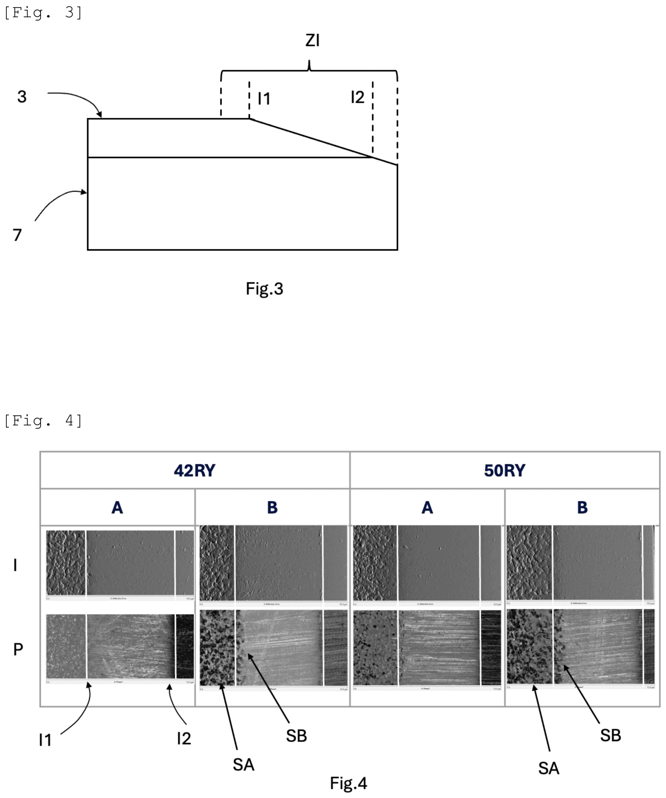

   La figure 3 représente un substrat comprenant une première couche préparée en vue de sa caractérisation ;
[Fig. 4]
   La figure 4 représente des images PFM de premières couches ayant subi ou non un traitement par nettoyage ;
[Fig. 5]

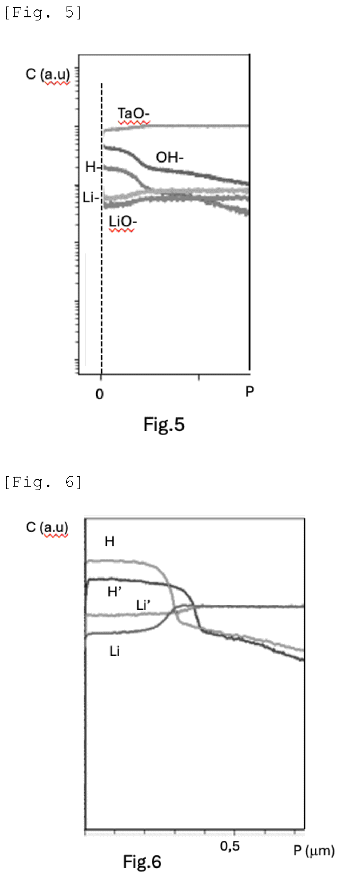

   La figure 5 représente une mesure par spectrométrie de masse à ions secondaires (SIMS) de la concentration en certains éléments dans la profondeur d'une première couche ayant subi un nettoyage ;
[Fig. 6] [Fig. 7a][Fig. 7b]

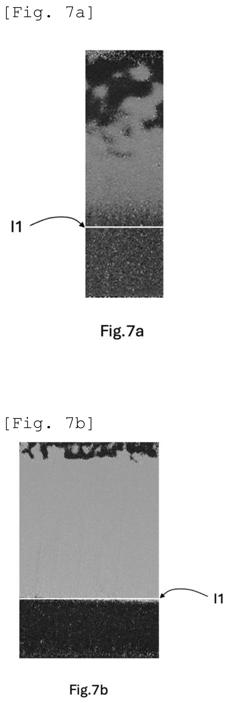

   Les figures 6,7a,7b représentent des mesures par spectrométrie de masse à ions secondaires (SIMS) et des images de phases PFM d'une première couche ayant subi un nettoyage acide et d'une première couche ayant subi un nettoyage acide compensée par un nettoyage dans une solution comprenant du lithium.

### DESCRIPTION DETAILLEE DE L'INVENTION

L'invention concerne un procédé de préparation d'une couche mince monodomaine 3' en un matériau ferroélectrique monocristallin transférée d'un substrat donneur 1 sur un substrat support 7 par une technique de transfert incluant une implantation d'espèces légères dans le substrat donneur 1. Plusieurs modes de réalisation de cette étape de fourniture d'une couche mince sont possibles.

Suivant un premier mode de réalisation, représenté sur les étapes 1A à 1F de la figure 1, le substrat donneur 1 est composé d'un bloc massif, monocristallin et monodomaine de matériau ferroélectrique, par exemple de LiTaO3, LiNbO3, LiAlO3, BaTiO3, PbZrTiO3, KNbO3, BaZrO3, CaTiO3, PbTiO3 ou de KTaO3. Préférentiellement, ce matériau est à base de lithium, par exemple du tantalate de lithium ou du niobate de lithium. Le substrat donneur 1 peut prendre la forme d'une plaquette, circulaire, de dimension normalisée, par exemple de 150 mm ou 200 mm de diamètre. Mais l'invention n'est nullement limitée à ces dimensions ou à cette forme. Le substrat donneur peut avoir été prélevé d'un lingot de matériau ferroélectrique, ce prélèvement ayant été réalisé de manière à ce que le substrat donneur 1 présente une orientation cristalline prédéterminée. L'orientation est choisie en fonction de l'application visée. Ainsi, il est usuel de choisir une orientation comprise entre 30° et 60°RY, ou entre 40° et 50°RY, dans le cas où l'on souhaite exploiter les propriétés d'une couche mince en LiTaO3 pour former un filtre SAW. Mais l'invention n'est nullement limitée à une orientation cristalline particulière ni à une application particulière.

Quelle que soit l'orientation cristalline du substrat donneur 1, le procédé comprend l'introduction dans le substrat donneur 1 d'au moins une espèce dite « légère », notamment des espèces choisies parmi les gaz inertes ou l'hydrogène. Cette introduction peut correspondre à une implantation, c'est-à-dire un bombardement ionique d'une face plane 4 du substrat donneur 1 par des espèces légères, telles que des ions d'hydrogène et/ou d'hélium.

De façon connue en soi, et comme cela est représenté sur la figure 1B, les ions implantés forment un plan de fragilisation 2 délimitant une première couche 3 de matériau ferroélectrique à transférer qui est située du côté de la face plane 4 et une autre partie 5 formant le reste du substrat.

La nature, la dose des espèces implantées et l'énergie d'implantation sont choisies en fonction de l'épaisseur de la couche que l'on souhaite transférer et des propriétés physico-chimiques du substrat donneur. Dans le cas d'un substrat donneur 1 en LiTaO3, on pourra ainsi choisir d'implanter une dose d'hydrogène comprise entre 1^{E}16 et 5^{E}17 at/cm² avec une énergie comprise entre 30 et 300keV pour délimiter une première couche 3 de l'ordre de 200 à 2000 nm.

Dans une étape suivante, représentée sur l'étape 1C de la figure 1, on assemble la face plane 4 du substrat donneur 1 avec une face 6 d'un substrat support 7. Le substrat support 7 peut présenter la même dimension et la même forme que celles du substrat donneur 1. Pour des raisons de disponibilité et de coût, le substrat support 7 est une plaquette de silicium, monocristallin ou polycristallin. Mais plus généralement, le substrat support 7 peut être constitué de tout matériau, par exemple du silicium, du saphir ou du verre, et présenter toute forme.

Dans un mode de mise en œuvre particulier, le substrat support 7 comprend un substrat de base 7b, par exemple en silicium monocristallin, sur lequel est disposée une couche de piégeage de charges électriques 7a (désignées plus simplement « couche de piégeage » dans la suite de cette description). Le substrat de base 7b peut présenter une résistivité élevée, supérieure à 1000 ohms.cm ou plus conventionnelle, inférieure à 1000 ohms.cm.

La couche de piégeage 7a peut être de nature très variée. D'une manière générale, il s'agit d'une couche non monocristalline présentant des défauts structurels, tels que des dislocations, des joints de grains, des zones amorphes, des interstices, des inclusions, des pores... Ces défauts structurels forment des pièges pour les charges susceptibles de circuler dans le matériau, par exemple au niveau de liaisons chimiques non complètes ou pendantes. On prévient ainsi la conduction dans cette couche 7a qui présente en conséquence une résistivité élevée.

D'une manière générale, la couche de piégeage 7a peut présenter une épaisseur comprise entre 10 nm et 30 micromètres, préférentiellement entre 50 nm et 5 micromètres.

Selon une approche possible, et pour des raisons de simplicité de mise en œuvre, la couche de piégeage 7a est formée d'une couche de silicium polycristallin. Cette couche peut être formée par dépôt sur une première face du substrat de base 7b. Dans ce cas, et afin de chercher à préserver la qualité polycristalline de cette couche au cours des traitements thermiques que peut subir le substrat support 7, on peut avantageusement prévoir une couche amorphe, en dioxyde de silicium par exemple, sur le substrat de base 7b avant le dépôt de la couche de piégeage 7a.

On peut alternativement former la couche de piégeage 7a par une implantation d'espèce relativement lourde, tel que de l'argon, dans une épaisseur superficielle du substrat de base 7b, afin d'y former les défauts structurels constituant les pièges électriques. On peut également former cette couche de piégeage 7a par porosification d'une épaisseur superficielle du substrat de base 7b, du côté de sa première face, ou par toute autre méthode apte à former des défauts structurels dans une épaisseur superficielle du support, ces défauts structurels étant aptes à piéger des charges électriques.

Selon une approche particulièrement avantageuse, la couche de piégeage 7a est constituée d'un oxyde riche en silicium, déposé sur la première face du substrat de base 7b. Par « oxyde riche en silicium » on désigne un oxyde comportant une concentration atomique de silicium comprise entre 50% et 99,9%. L'oxygène et, éventuellement, de l'azote sont présents dans cette couche dans des concentrations atomiques sous-stœchiométriques. De préférence cet oxyde présente une concentration atomique de silicium comprise entre 70% et 90% et une concentration atomique d'oxygène comprise entre 10% et 30%. Elle peut présenter de l'azote dans une concentration atomique comprise entre 8% et 45%.

Une couche d'oxyde riche en silicium est usuellement formée d'une matrice amorphe. Cette matrice amorphe peut comprendre des inclusions cristallines de silicium ou des grains cristallins de silicium, la densité et la taille de ces inclusions et/ou de ces grains dans la matrice amorphe étant dépendantes des proportions relatives d'oxygène, d'azote et de silicium dans la couche et des traitements thermiques que celle-ci a reçus. Dans les cas extrêmes, une couche d'oxyde riche en silicium peut être entièrement amorphe ou polycristalline, la matrice amorphe étant alors dans ce dernier cas réduite à des inclusions amorphes présentes entre les grains du poly cristal. Une telle couche présente l'avantage de présenter une densité de défauts, formant des pièges pour les charges électriques, particulièrement élevée. Elle est donc susceptible de présenter une résistivité très élevée, jusqu'à environ 10^12 ohm.cm. On pourra trouver des détails complémentaires sur la formation de la couche de piégeage 7a sous la forme d'une couche d'oxyde riche en silicium dans les publications WO2024115410, WO2024115411 et WO2024115414.

Revenant à la description générale du procédé de fourniture représenté sur la figure 1, et préalablement à l'étape d'assemblage, il peut être envisagé de préparer les faces des substrats à assembler par une étape de nettoyage, brossage, séchage, polissage, ou une activation, par exemple par plasma.

L'étape d'assemblage peut correspondre à la mise en contact intime du substrat donneur 1 avec le substrat support 7 par adhésion moléculaire et/ou collage électrostatique. Optionnellement, pour faciliter l'assemblage des deux substrats 1,7 notamment lorsqu'ils sont assemblés par collage direct, au moins une couche intercalaire amorphe peut être formée préalablement à l'assemblage, soit sur la face plane 4 du substrat donneur 1, soit sur la face plane 6 à assembler du substrat support 7, soit sur les deux. Cette couche intercalaire est par exemple constituée d'oxyde de silicium, de nitrure de silicium, d'oxynitrure de silicium. Elle peut présenter une épaisseur comprise entre quelques nanomètres et quelques microns.

On privilégiera une couche intercalaire présentant une faible concentration en hydrogène ou faisant barrière à la diffusion d'hydrogène pour suivre les enseignements du document WO2020200986 et éviter ainsi la formation d'une zone multidomaine à l'interface entre la première couche 3 et la couche intercalaire amorphe, du côté de la seconde face de la première couche 3. La couche intercalaire peut être élaborée selon les différentes techniques connues de l'état de l'art, tels des traitements thermiques d'oxydation ou de nitruration, des dépôts chimiques (PECVD, LPCVD...), etc.

A l'issue de cette étape d'assemblage, on dispose d'un ensemble comprenant les deux substrats associés, la face plane 6 du substrat support 7 adhérant à la face plane 4 du substrat donneur 1.

L'ensemble est alors traité pour détacher la première couche 3 de matériau ferroélectrique du substrat donneur 1, par exemple par clivage au niveau du plan de fragilisation 2.

Cette étape de fracture peut ainsi comprendre l'application à l'ensemble d'un traitement thermique dans une gamme de température de l'ordre de 80°C à 300° pour permettre le transfert de la première couche 3 sur le substrat support 7. En remplacement ou en complément du traitement thermique, cette étape peut comprendre l'application d'une lame ou un jet de fluide gazeux ou liquide au niveau du plan de fragilisation 2.

A la suite de cette étape de fracture, on obtient la structure 9 représentée à la figure 1D. Cette structure 9 comprend la première couche 3 de matériau ferroélectrique monocristallin comprenant une première face libre 8 et une deuxième face 4 disposée sur le substrat support 7.

La figure 2 représente un deuxième mode de mise en œuvre conduisant à fournir cette même structure 9. Ce deuxième mode de réalisation est particulièrement adapté à la réalisation d'une structure 9 hétérogène, dans laquelle la première couche 3 présente un coefficient de dilatation thermique (dans le plan principal définissant cette couche) bien différent de celui du substrat support 7, par exemple présentant une différence de plus de 10% (à température ambiante).

Ce deuxième mode de mise en œuvre diffère principalement du premier mode de mise en œuvre par la nature du substrat donneur 1. Par souci de concision, on ne présente donc ici que les éléments de ce deuxième mode de mis en œuvre se différenciant du premier, toutes les autres caractéristiques du premier mode de réalisation pouvant donc être prévues. Par ailleurs, on pourra trouver plus de détails sur ce deuxième mode de mise en œuvre dans le document EP3646374.

En référence à l'étape 2A de la figure 2, le substrat donneur 1 comprend dans ce cas une couche de matériau ferroélectrique monocristallin 1a disposée sur un substrat manipulateur. La couche de matériau ferroélectrique possède les mêmes propriétés que celles décrites pour le bloc massif de matériau ferroélectrique en relation avec le premier mode de réalisation.

Le substrat manipulateur 1b est avantageusement constitué d'un matériau (ou d'une pluralité de matériaux) lui conférant un coefficient de dilatation thermique proche de celui composant le substrat support 7. Par « proche », on signifie que la différence de coefficient de dilatation thermique du substrat manipulateur 1b et de celui du support est moindre, en valeur absolue, que la différence de dilatation thermique du bloc massif du matériau ferroélectrique et de celui du substrat support 7.

Préférentiellement, le substrat manipulateur 1b et le substrat support 7 présentent un coefficient de dilatation thermique identique. Lors de l'assemblage du substrat donneur 1 et du substrat support 7, on forme un ensemble apte à supporter un traitement thermique à une température relativement élevée. Pour des raisons de simplicité de mise en œuvre, cela peut être obtenu en choisissant le substrat manipulateur 1b pour qu'il soit constitué du même matériau que celui du substrat support 7.

Pour former le substrat donneur 1 de ce mode de réalisation, on assemble préalablement un bloc massif de matériau ferroélectrique avec le substrat manipulateur 1b, par exemple selon une technique de collage par adhésion moléculaire telle que cela a été décrit préalablement ou à l'aide d'une couche adhésive, par exemple un adhésif polymère. Avant l'assemblage on peut donc avoir prévu la formation d'une couche d'adhésion (par exemple par dépôt d'oxyde de silicium et/ou de nitrure de silicium, d'une couche adhésive, par exemple un polymère) sur l'une et/ou l'autre des faces mises en contact. Puis, on forme la couche de matériau ferroélectrique 1a par amincissement, par exemple par meulage et/ou polissage mécanochimique et/ou gravure. L'assemblage peut comprendre l'application d'un traitement thermique de faible température (compris par exemple entre 50 et 300°C, typiquement 100°C) permettant de renforcer suffisamment l'énergie de collage pour permettre l'étape suivante d'amincissement.

Le substrat manipulateur 1b est choisi pour présenter une épaisseur sensiblement équivalente à celle du substrat support 7. L'étape d'amincissement est conduite de telle sorte que la couche de matériau ferroélectrique 1a présente une épaisseur suffisamment faible pour que les contraintes générées lors des traitements thermiques appliqués dans la suite du procédé soient d'intensité réduite. Dans le même temps, cette épaisseur est suffisamment importante pour pouvoir y prélever la première couche 3, ou une pluralité de telles couches. Cette épaisseur peut par exemple être comprise entre 5 et 400 microns.

Les étapes suivantes du procédé de ce second mode de mise en œuvre sont équivalentes à celles des étapes décrites dans le premier mode de réalisation. On procède à l'implantation d'espèces légères au sein de la couche de matériau ferroélectrique 1a pour générer un plan de fragilisation 2 qui marque la séparation de la couche mince 3 du reste 5 du substrat donneur 1, comme cela est représenté sur la figure 2B. Cette étape est suivie de l'étape d'assemblage du substrat donneur 1 sur le substrat support 7, tel que cela est représenté sur la figure 2C. On détache ensuite la première couche 3 du reste 5 du substrat donneur 1 pour obtenir la structure 9 représentée sur la figure 2D.

Ce mode de mise en œuvre est avantageux en ce que l'assemblage formé du substrat donneur 1 et du substrat support 7 peut être exposé à une température bien plus élevée que celle appliquée dans le cadre du premier mode de mise en œuvre, sans risque de fracture incontrôlée de l'un des substrats ou de délamination du substrat donneur 1 de la première couche 3. La structure équilibrée, en termes de coefficient de dilatation thermique de cet assemblage, permet ainsi de faciliter l'étape de détachement de la première couche 3 en exposant l'assemblage à une température relativement élevée, par exemple comprise entre 100 et 500 °C.

Quel que soit le mode de mise en œuvre choisi, et comme cela a été précisé en introduction de cette demande, des étapes de finition de la première couche 3 sont ensuite nécessaires pour améliorer sa qualité cristalline et de surface, et fournir une couche mince 3' dont l'épaisseur correspond à, ou s'approche de, une épaisseur cible.

Par souci de précision, on désigne dans la présente demande par « première couche » la couche prélevée du substrat donneur 1 et reportée sur le substrat support 7 après l'étape de fracture, et par « couche mince » la couche de nature monodomaine obtenue à l'issue des étapes de finition.

Ces étapes de finition 1E, 2E représentées schématiquement sur la figure 1 et la figure 2, visent notamment à éliminer une couche superficielle écrouie et rugueuse, résultant du clivage et du détachement de la couche mince 3 du reste du substrat donneur 1.

Dans le cadre de la présente description, les étapes de finition comprennent un traitement thermique de la première couche 3 prélevée. Ce traitement thermique permet de guérir des défauts cristallins présents dans cette couche 3, voire même à réduire la rugosité de sa face libre 8. En outre, il contribue à consolider son adhésion au substrat support 7. Le traitement thermique porte la structure à une température comprise entre 300°C et la température de Curie du matériau ferroélectrique pendant une durée comprise entre 30 minutes et 10 heures. Il peut être conduit dans une atmosphère neutre ou comprenant de l'oxygène.

Pour éviter toute ambiguïté, on souligne que l'étape de traitement thermique de finition est bien distincte du traitement thermique de fracture appliquée à la structure assemblée. Elle est notamment réalisée dans un équipement différent de celui utilisé pour appliquer le traitement thermique de fracture.

On prévoit également, après le traitement thermique de finition, une étape d'amincissement de la première couche 3. Cette étape vise à éliminer une portion superficielle multi-domaine de la première couche 3, cette portion pouvant apparaitre au cours de l'étape précédente de traitement thermique.

L'amincissement permet également de fournir une couche mince monodomaine 3' dont l'épaisseur correspond à une épaisseur cible, comme cela a été évoqué précédemment. Cet amincissement peut, d'une manière générale, correspondre au polissage de la première face libre 8 de la couche mince 3, par exemple par des techniques d'amincissement mécanique, mécanochimique. Il peut s'agir également d'un amincissement réalisé par gravure ionique, par exemple par gravure par ions réactifs ou par toute autre technique.

Les étapes 1F et 2F des figures 1 et 2 représentent la structure 9 obtenue à l'issue de ces traitements, une couche mince monodomaine 3' étant disposée sur le substrat support 7.

Pour caractériser l'épaisseur d'une éventuelle portion superficielle multidomaine de la première couche 3 à l'issue du traitement thermique, la Demanderesse a développé une technique de caractérisation originale. Cette technique comprend une première étape consistant à procéder à un enlèvement en biseau de la structure 9 (et plus particulièrement de la première couche 3 de cette structure 9), par polissage mécano-chimique, comme cela est illustré sur la figure 3. Le biseau permet d'exposer cette première couche 3 dans toute son épaisseur jusqu'au substrat support 7 sous-jacent. A la suite de cette première étape, on procède à une imagerie par microscopie de force piézoélectrique (PFM pour « Piezoresponse Force Microscopy » dans sa désignation anglo-saxonne) d'une zone d'inspection ZI incluant toute la surface exposée du biseau. Les images produites par cette technique incorporent donc une portion de la surface libre de la première couche 3, toute la surface exposée du biseau dans l'épaisseur de la couche, et une portion du support 7. On a délimité sur la figure 3 la surface exposée du biseau dans l'épaisseur de la couche par les lignes de délimitation I1, I2.

En microscopie de force piézoélectrique (PFM), une pointe AFM conductrice est mise en contact avec la surface d'un matériau ferroélectrique ou piézoélectrique. Une tension alternative est alors appliquée entre la pointe et l'échantillon, créant un champ électrique à l'intérieur du matériau. Sous l'effet de ce champ, l'échantillon subit une dilatation ou une contraction locale, en fonction de l'orientation de la polarisation ferroélectrique du domaine situé sous la pointe. Ce mouvement entraîne une déformation de la pointe AFM, qui est ensuite détectée pour produire des images de topographie et de phase en scannant l'échantillon avec cette pointe. Dans l'imagerie PFM, la différence de phase entre la tension appliquée et la réponse piézoélectrique est directement liée à l'orientation des domaines ferroélectriques. L'amplitude de cette réponse permet, quant à elle, d'identifier la position des parois de domaine.

Sur l'image de phase, le caractère multidomaine de l'échantillon conduit à former une image tachetée, « en peau de léopard », qui révèle la présence de la pluralité de domaines. Au contraire, le caractère monodomaine se révèle comme une image de phase relativement uniforme.

En mesurant l'étendue de portion tachetée sur l'image de phase PFM du biseau, on peut déterminer l'épaisseur de la portion superficielle multidomaine.

On a ainsi représenté sur la figure 4 de telles analyses réalisées sur une première couche 3 après son report sur un support 7 et après lui avoir appliqué un traitement thermique à 500°C dans une atmosphère neutre. Dans les expérimentations menées, la première couche 3 était en tantalate de lithium d'orientation cristalline 42RY (partie gauche de la figure 4) ou d'orientation cristalline 50RY (partie droite de la figure 4).

Pour chaque première couche préparée, on a appliqué la technique de caractérisation PFM présentée ci-dessus. Dans certaines préparations, le procédé était dépourvu de toute étape de traitement de la première couche 3 entre l'étape de fracture et le traitement thermique (colonne A). Dans d'autres préparations, le procédé comprenait une étape de nettoyage entre l'étape de fracture et le traitement thermique (colonne B). Cette étape de nettoyage comprenait le brossage de la face libre 8 de la première couche 3 et, simultanément, la dispense d'eau désionisée sur cette face libre 8.

Dans chaque colonne A et B, on a représenté l'image d'intensité PFM (ligne supérieure I) et l'image de phase PFM (ligne inférieure P) du biseau préalablement formé dans les structures 9 sous test.

Il est tout à fait visible sur les images PFM de la figure 4, que les premières couches 3 ayant subi un nettoyage (colonnes B) présentent une image de phase tachetée à gauche de la ligne de délimitation I1 (zone SA sur la figure 4), qui témoigne du caractère multidomaine de la surface de la première couche 3. On voit que cette zone d'image tachetée s'étend à droite de la ligne de délimitation I1, ce qui indique que le caractère multidomaine s'étend en profondeur dans la première couche (zone SB sur la figure 4).

En comparaison, les images PFM de la figure 4 correspondant aux premières couches n'ayant pas subi de nettoyage (colonnes A) apparaissent relativement lisses, sans apparence tachetée, ce qui témoigne du caractère entièrement monodomaine de cette couche.

Il apparaît donc qu'une absence de nettoyage de la couche mince entre l'étape de fracture et le traitement thermique tend à prévenir l'apparition d'une épaisseur superficielle multidomaine dans la première couche, ou pour le moins réduire son extension dans la profondeur.

La Demanderesse savait, préalablement à ces résultats, que les ions Li+ de la première couche 3, du fait de son traitement préalable (implantation, recuit de fracture) étaient particulièrement mobiles et susceptibles de s'y mouvoir pour, par exemple s'agglomérer en surface. Les expérimentations complémentaires réalisées, comme celles présentées dans la figure 4, lui ont donné l'intuition que les échanges entre les ions H+ de l'environnement (par exemple l'eau du nettoyage) et les ions Li+ disponibles dans la première couche 3 étaient, dans une première couche ayant été implantée et recuite lors de l'étape de fracture, particulièrement exacerbés. Ces échanges tendent à dépléter en lithium la première couche 3 au niveau de sa surface et, dans le même temps, de l'enrichir en hydrogène. Par « au niveau de sa surface », on désigne une épaisseur de la première couche pouvant s'étendre sous la face libre 8 de cette première couche 3 jusqu'à quelques dizaines, voire quelques centaines de nanomètres.

On a ainsi représenté sur la figure 5 une mesure par spectrométrie de masse à ions secondaires (SIMS) de la concentration C en certains éléments dans la profondeur D de la couche première couche 3 (la profondeur 0 correspondant à la face libre de la première couche 3). Cette mesure a été réalisée sur une première couche ayant subi, entre l'étape de fracture et de traitement thermique, un nettoyage par brossage de la face libre 8 de la première couche 3 et, simultanément, la dispense d'eau désionisée sur cette face libre 8 (correspondant donc à un échantillon identique à celui de la colonne B sur la figure 4). On observe sur le graphe de la figure 5, que la couche ainsi traitée apparaît déplétée en lithium au niveau de sa face libre, la concentration en LiO- et Li- étant décroissante en s'approchant de cette face. Dans le même temps, on observe sur ce graphe que la première couche est enrichie en hydrogène en s'approchant de cette face libre.

La Demanderesse a eu l'intuition que ce phénomène, qui peut s'apparenter à un échange protonique, et son résultat de déplétion en lithium au niveau de la face libre 8 de la première couche 3 étaient le moteur de la formation des inversions de polarité provoquées par le traitement thermique, ces inversions étant à l'origine de la portion superficielle multidomaine de cette première couche.

On rappelle que le phénomène d'échange protonique comprend la substitution partielle ou complète des ions lithium L- par des protons H+, par exemple des protons fournis par un bain acide. Il n'était toutefois pas attendu qu'un tel phénomène se produise avec autant d'intensité en exposant simplement le matériau à de l'eau désionisée, comme cela a été rendu apparent sur la figure 5. Il est généralement reconnu qu'un tel échange dépend fortement de la force de l'acide du bain (tel que mesuré par sa constante d'acidité pKa). Il apparaît donc que la première couche 3 présente, du fait des étapes qui ont conduit à son prélèvement, une faculté extraordinaire à substituer le lithium qui la compose avec l'hydrogène de son environnement.

Après le traitement thermique de l'étape de finition, la première couche 3 ne présente plus cette faculté. Les étapes qui suivent ce traitement thermique, notamment les étapes de nettoyage, ne conduisent plus à la nucléation des domaines, même après application d'un autre traitement thermique.

La présente invention tire profit des résultats, des observations et de ces intuitions pour proposer un procédé de préparation de la première couche 3 visant à limiter l'épaisseur de la portion superficielle multidomaine, voire même à la faire disparaitre.

Selon l'invention le procédé de préparation de la couche mince ferroélectrique est conduit de manière maitrisée, cette maitrise visant à tempérer ce phénomène de déplétion en lithium/enrichissement en hydrogène, c'est-à-dire prévenir son occurrence ou compenser ses effets, entre l'étape de fracture et le traitement thermique, ainsi que pendant le traitement thermique lui-même.

Ainsi, et selon une première approche qui forme un aspect en soi de la présente invention, le procédé de préparation de la couche mince 3' est conduit, entre l'étape de fracture et le traitement thermique ainsi que pendant le traitement thermique, de manière à prévenir le phénomène de déplétion en lithium/enrichissement en hydrogène. On évite pour cela d'exposer la première couche 3 à une solution aqueuse ou à un environnement humide. Comme on l'a montré, l'eau présente dans cette solution ou dans cet environnement favorise la déplétion en lithium superficiellement dans la première couche 3 et donc la création, in fine, d'une portion superficielle multidomaine dans la première couche 3.

Dans cette première approche, le procédé de préparation est notamment dépourvu, entre la fracture du substrat donneur 1 et le traitement thermique de la première couche 3, de tout traitement exposant la première couche à une solution aqueuse, notamment de traitement aqueux de nettoyage de la face libre.

En particulier, on ne réalise pas de nettoyage dit « standard » ou nettoyage RCA (« RCA clean » selon la terminologie du domaine, acronyme de Radio Corporation of America). Un tel nettoyage, très répandu dans le domaine de la microélectronique, comprend l'immersion successive du substrat dans une chimie humide formée de SC1 (« Standard Clean 1 » pour « nettoyage standard 1 ») contenant de l'hydroxyde d'ammonium (NH4OH), du peroxyde d'hydrogène (H2O2) et de l'eau ultra pure, puis dans une chimie humide formée de SC2 (« Standard Clean 2 » pour « nettoyage standard 2 ») contenant de l'acide chlorhydrique (HCl), du peroxyde d'hydrogène (H2O2) et de l'eau ultra pure. Ces immersions sont précédées et/ou suivies par le rinçage du substrat par immersion dans une solution de rinçage composée d'eau ultra pure ou à base d'eau ultrapure.

Dans un mode de mis en œuvre particulier de cette première approche visant à prévenir le phénomène de déplétion en lithium/enrichissement en hydrogène, le traitement thermique de l'étape de finition est appliqué directement, sans autre étape de traitement intermédiaire, après l'étape de fracture. On évite de la sorte tout risque de provoquer la déplétion en lithium superficiellement dans la première couche 3.

En prenant de telles précautions entre l'étape de fracture et la fin du traitement thermique, il est possible d'obtenir une première couche présentant une portion superficielle multidomaine présentant une épaisseur inférieure à 100nm, parfois inférieure à 50 nm, voire même étant dépourvue de toute portion superficielle multidomaine.

On peut procéder à l'issue du traitement thermique, et comme cela a été présenté dans la section précédente, à un amincissement de la première couche 3 pour éliminer, le cas échéant, cette portion superficielle multidomaine et fournir une couche mince 3' monodomaine présentant une épaisseur désirée.

Selon une deuxième approche, qui forme en soi un second aspect de l'invention (mais qui peut être combinée avec la première approche), le procédé de préparation de la couche mince monodomaine est conduit, entre l'étape de fracture et le traitement thermique ainsi que pendant le traitement thermique lui-même, de manière à compenser les effets de la déplétion en lithium de la première couche au niveau de sa face libre.

La déplétion en lithium de la première couche peut être apparue au cours des étapes précédentes le traitement thermique de l'étape de finition, par exemple au cours d'une étape de nettoyage à l'aide d'une solution aqueuse de la première couche 3 après l'étape de fracture. Il peut s'agir d'un nettoyage standard, cette étape visant notamment à éliminer les particules pouvant s'être déposées sur la première couche 3 pendant la fracture. Cette étape de nettoyage peut, alternativement, être conforme à celle prévue dans le document WO2024223276, à base d'eau désionisée. On a vu qu'une telle étape tendait à dépléter la première couche en lithium au niveau de sa face libre.

Par « compenser les effets » on signifie que l'on prévoit, avant ou pendant le traitement thermique, une étape d'introduction de lithium dans une épaisseur superficielle de la première couche 3. Cette étape d'introduction vise à rehausser la concentration en lithium de cette épaisseur superficielle, afin de compenser au moins en partie la déplétion qui a pu se créer. L'épaisseur superficielle dans laquelle est introduit ce lithium peut s'étendre sur une profondeur de plusieurs centaines de nm, par exemple sur plus de 200 nm ou sur plus de 300 nm, nm depuis la face libre de la première couche. L'étape d'introduction du lithium peut être accomplie conformément aux enseignements du document US11398595.

Cette étape d'introduction peut être menée pour viser une concentration en lithium cible dans l'épaisseur superficielle. On peut également chercher à réduire le gradient de concentration en lithium dans cette épaisseur superficielle sous un gradient cible.

L'étape d'introduction peut être mise en œuvre avant le traitement thermique, par exemple en immergeant la première couche 3 dans une solution comprenant du lithium. Cette solution peut être une solution aqueuse ou non aqueuse de LiNO3. Il peut s'agir d'une solution comprenant du LiCl, LiNO3 ou LiBF4 dans un solvant organique tel que de l'acétonitrile, du diméthylsulfoxyde, de l'éthanol, de l'isopropanol. Il peut également s'agir de Li2CO3 ou de LiOH en suspension dans un solvant organique, tel que de l'éthanol, du toluène ou de l'acétonitrile.

L'étape d'introduction peut également comprendre l'immersion de la première couche 3 dans un sel de lithium fondu, tel que LiNO3-KNO3 ou le LiCl-KCl. Il peut s'agir de plonger la structure comprenant la première couche 3 dans un bain présentant une température assurant le caractère liquide du sel de lithium (en température de 350°C à 450°C lorsqu'il s'agit de LiCl-KCl ou de 130°C à 300°C pour du LiNO3-KNO3) pendant une durée typiquement comprise entre 10 min et 2h.

Plutôt que d'immerger la couche dans un fluide comprenant du lithium, on peut plus simplement réaliser l'étape d'introduction en déposant sur et en contact avec la première couche 3, une couche réservoir de lithium. Cette couche réservoir peut être composée ou comprendre du lithium métallique ou un précurseur de lithium. Il peut notamment s'agir de Li2CO3, de Li3N, de Li2O et /ou de LiNO3. Le lithium contenu dans cette couche réservoir peut migrer vers la première couche 3, par diffusion. Cette diffusion peut être favorisée en élevant modérément la température de l'empilement couche réservoir-première couche.

Selon un mode de mise en œuvre très avantageux, le dépôt peut être réalisé avant le traitement thermique de l'étape de finition, et ce traitement thermique est réalisé avec la couche réservoir présente sur la première couche 3. L'étape d'introduction du lithium dans la première couche 3 est alors réalisée pendant le traitement thermique lui-même.

Il existe d'autre manière de mettre l'étape d'introduction pendant le traitement thermique lui-même, par exemple en opérant le traitement thermique de l'étape de finition pour recuire la première couche 3 dans une atmosphère comprenant du lithium.

Cette atmosphère peut être produite par un flux gazeux comprenant un organométallique à base de lithium tel que le butyllithium (BuLi)ou le phényllithium (PhLi). Le flux gazeux peut être introduit dans une chambre dans laquelle réside la structure comprenant la première couche 3, afin d'y exposer la face libre 8 de cette couche.

Cette atmosphère comprenant du lithium peut être obtenue par sublimation à partir d'une source solide de lithium. Dans cette approche, la source solide peut être disposée sous forme de lit. Un flux d'un gaz porteur circule au-dessus du lit contenant la source solide, cette source se sublimant pour incorporer des espèces à base de lithium dans le flux gazeux. Le lit peut être disposé en amont de la chambre ou dans la chambre dans laquelle réside le lit de source solide. Le lit peut être composé d'une poudre, par exemple une poudre comprenant du LiTaO3, du Li2O, du Li2CO3 et/ou du LiCl.

La température du traitement thermique et sa durée peuvent être choisies pour incorporer une quantité définie de lithium dans la première couche. Il peut s'agir, comme on l'a déjà énoncé, d'atteindre une concentration de lithium, ou un gradient de concentration de lithium, prédéfinie dans une épaisseur superficielle de cette première couche 3.

On peut naturellement combiner les deux approches exposées, c'est-à-dire à la fois prévenir la déplétion en lithium de la première couche 3 et prévoir une étape d'introduction de lithium dans cette première couche 3.

Dans un tel cas, on évite d'exposer la première couche 3, au cours de l'étape d'introduction de lithium, à une solution aqueuse. Ainsi, si l'on immerge la première couche 3 dans une solution comprenant du lithium, on choisit cette solution pour qu'elle soit non aqueuse. Il peut s'agir d'une solution d'un matériau contenant du lithium dans un solvant organique, comme on l'a déjà proposé.

Pour illustrer un bénéfice de l'invention, on a réalisé une expérimentation visant à préparer une première couche 3 en tantalate de lithium, selon le procédé présenté en début de la présente description. Entre l'étape de fracture et le traitement thermique, on a immergé la première couche en tantalate de lithium à une solution acide (à base de HCl) et à température relativement élevée (80°C) afin de favoriser les échanges protoniques. Une mesure SIMS réalisée après cette étape d'immersion, et présentée sur la figure 6a, permet de constater que ces échanges ont conduit à former une épaisseur superficielle de cette couche présentant une forte concentration en hydrogène (courbe marquée H) et une forte déplétion en lithium (courbe marquée L).

La figure 7a représente une image de phase PFM de la première couche 3 (réalisée selon la même technique du biseau exposé précédemment) ayant subi cette immersion dans un milieu acide, puis recuite au cours du traitement thermique de l'étape de finition. On a délimité sur cette figure 7a par la ligne de délimitation I1, la surface libre 8 de la couche et la surface du biseau dans l'épaisseur de la première couche 3. On note la présence d'une portion multidomaine sur la face libre et sous la face libre de cette première couche.

Dans une autre expérimentation, on a également reproduit l'étape d'immersion dans une solution acide et en température d'une première couche de tantalate de lithium. Puis, et avant de procéder au traitement thermique, on a cherché à compenser la déplétion de lithium en immergeant la première couche 3 dans une solution aqueuse saturée en LiNO3 à 80°C. Les mesures SIMS réalisées après cette seconde immersion sont présentées sur la figure 6. On y observe que, suite à ce traitement dans une solution saturée en LiNO3, l'épaisseur superficielle présente une concentration en hydrogène (courbe marquée H') réduite et une déplétion en lithium (courbe marquée L') moins marquée.

La figure 7b représente une image de phase PFM de cette première couche 3 après que cette couche ait été recuite au cours du traitement thermique. On a également délimité sur cette figure 7b par la ligne de délimitation I1, la surface libre 8 de la couche et la surface du biseau dans l'épaisseur de la première couche 3. On note que la portion multidomaine s'étend sous la face libre 8 de la première couche 7, de manière très limitée, et bien moins profondément que dans le cas de la figure 7a.

On comprend donc qu'en maitrisant le procédé de préparation de la couche mince monomanie, entre l'étape de fracture et le traitement thermique ainsi que pendant le traitement thermique, de manière à prévenir l'occurrence, ou compenser les effets de déplétion en lithium/enrichissement en hydrogène susceptibles de se produire sur la face libre 8 de la première couche 3, on réduit fortement la présence d'une portion superficielle multidomaine (voire même on évite sa formation) à l'issue du traitement thermique de l'étape de finition. L'étape d'amincissement de la première couche et le procédé de préparation dans son ensemble peuvent être réduits et simplifiés.

Dans certains cas, la première couche 3 ne développe pas de portion superficielle multidomaine au cours du traitement thermique de finition. Il n'est pas, dans ce cas, impératif de faire suivre ce traitement thermique d'une étape d'amincissement. Si un tel amincissement est nécessaire, par exemple pour éliminer une couche superficielle écrouie et rugueuse, résultant du clivage et de la fracture de la couche mince 3, cet amincissement peut être réalisé préalablement au traitement thermique.

Bien entendu l'invention n'est pas limitée aux modes de mise en œuvre décrits et on peut y apporter des variantes de réalisation sans sortir du cadre de l'invention tel que défini par les revendications.

## Revendications

1. Procédé de préparation d'une couche mince monodomaine (3') en matériau ferroélectrique monocristallin, comprenant les étapes suivantes:
- une implantation d'espèces dites « légères » dans une première face (4) d'un substrat donneur ferroélectrique (1) pour former un plan de fragilisation (2) et définir une première couche (3) entre le plan de fragilisation (2) et la première face (4) du substrat donneur (1);
- l'assemblage de la première face (4) du substrat donneur (1) à un substrat support (7);
- la fracture du substrat donneur (1) au niveau du plan de fragilisation (2) pour reporter la première couche (3) sur le substrat support et exposer une face libre (8) de la première couche (3);
- la finition de la première couche (3), cette finition comprenant un traitement thermique de la face libre (8) de la première couche (3), suivi d'un amincissement de la première couche (3) pour fournir la couche mince monodomaine (3');
le procédé étant **caractérisé en ce que** l'étape de finition de la première couche (3) comprend, avant ou pendant le traitement thermique, une étape d'introduction de lithium dans une épaisseur superficielle de la première couche (3).

2. Procédé de préparation selon la revendication précédente, dans lequel l'étape d'introduction est mise en en œuvre avant le traitement thermique.

3. Procédé de préparation selon la revendication précédente, dans lequel l'étape d'introduction comprend l'immersion de la première couche (3) dans une solution non aqueuse comprenant du lithium.

4. Procédé de préparation selon la revendication précédente, selon lequel la solution comprend du LiCl, LiNO3 ou LiBF4 dans un solvant organique, tel que l'acétonitrile (CH3CN), le diméthylsulfoxyde (DMSO), l'éthanol, l'isopropanol.

5. Procédé de préparation selon la revendication 4, selon lequel la solution contient du Li2CO3 ou du LiOH en suspension dans un solvant organique, tel que l'éthanol, le toluène ou l'acétonitrile.

6. Procédé de préparation selon la revendication 4, selon lequel l'étape d'introduction comprend l'immersion de la première couche (3) dans un sel de lithium fondu tel que LiNO3-KNO3, LiCl-KCl.

7. Procédé de préparation selon la revendication 1, selon lequel l'étape d'introduction est mise en œuvre pendant le traitement thermique.

8. Procédé de préparation selon la revendication précédente, comprenant le dépôt d'une couche réservoir comprenant du lithium sur la première couche (3) avant le traitement thermique.

9. Procédé de préparation selon la revendication 7, selon lequel l'étape d'introduction de lithium comprend le recuit de la première couche (3) dans une atmosphère comprenant du lithium.

10. Procédé de préparation selon la revendication précédente, selon lequel l'atmosphère comprenant du lithium est obtenue par sublimation à partir d'une source solide.

11. Procédé de préparation selon la revendication 9, selon lequel l'atmosphère comprenant du lithium est obtenue par un flux gazeux contenant du lithium.

12. Procédé de préparation selon l'une des revendications précédentes, dans lequel le procédé est dépourvu de tout traitement exposant la première couche (3) à une solution aqueuse entre l'étape de fracture du substrat donneur (1) et le traitement thermique de la première couche (3).

13. Procédé de préparation selon l'une des revendications 7 à 12 dans lequel le traitement thermique est appliqué directement, sans autre étape de traitement intermédiaire, après l'étape de fracture.

14. Procédé de préparation selon une des revendications précédentes, selon lequel le substrat support (7) comprend une couche de piégeage de charges électriques (7a).
